(19) Europäisches Patentamt
European Patent Office
Office européen des brevets

(11) **EP 4 354 200 A1**

(12) **EUROPEAN PATENT APPLICATION**

(43) Date of publication:
**17.04.2024 Bulletin 2024/16**

(21) Application number: **22200778.3**

(22) Date of filing: **11.10.2022**

(51) International Patent Classification (IPC):
**G02B 27/00** (2006.01)

(52) Cooperative Patent Classification (CPC):
**G02B 27/0043; G02B 5/1828; G02B 26/0808; G02B 27/005; G02B 27/1006; G03F 7/706847; G03F 7/706849; G03F 9/7065**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **ASML Netherlands B.V.**
**5500 AH Veldhoven (NL)**

(72) Inventors:
• **TUKKER, Teunis, Willem**
**5500 AH Veldhoven (NL)**

• **VAN VOORST, Peter, Danny**
**5500 AH Veldhoven (NL)**
• **ZHOU, Zili**
**5500 AH Veldhoven (NL)**
• **VAN GREEVENBROEK, Hendrikus, Robertus, Marie**
**5500AH Veldhoven (NL)**

(74) Representative: **ASML Netherlands B.V.**
**Corporate Intellectual Property**
**P.O. Box 324**
**5500 AH Veldhoven (NL)**

(54) **AN ABERRATION CORRECTION OPTICAL SYSTEM**

(57)    An optical arrangement for aberration correction, comprising: a beam dispersing element for spatially dispersing a broadband radiation beam in a first transverse direction; a focusing lens for focusing the broadband radiation beam subsequently to said dispersing, wherein said focusing lens is arranged such that the dispersed broadband radiation beam passes through at least one off-center position of the focusing lens in at least one pass, wherein said off-center position is a position displaced from a center of the focusing lens in a second transverse direction, wherein the first transverse direction and the second transverse direction are mutually perpendicular and parallel to a focal plane of the focusing lens; and at least one aberration compensating lens displaced in the second transverse direction with respect to at least part of the broadband radiation beam so as to substantially compensate for lateral chromatic aberration..

**Fig. 13**

EP 4 354 200 A1

**Description**

FIELD

The present invention relates to a broadband optical system for controlling a broadband optical beam, and in particular such a broadband optical system in relation to metrology applications in the manufacture of integrated circuits.

BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-ki lithography may be used to process features with dimensions smaller than the classical resolution limit of a lithographic apparatus. In such process, the resolution formula may be expressed as $CD = k_1 \times \lambda / NA$, where $\lambda$ is the wavelength of radiation employed, NA is the numerical aperture of the projection optics in the lithographic apparatus, CD is the "critical dimension" (generally the smallest feature size printed, but in this case half-pitch) and $k_1$ is an empirical resolution factor. In general, the smaller $k_1$ the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k1.

Metrology tools are used in many aspects of the IC manufacturing process, for example as alignment tools for proper positioning of a substrate prior to an exposure, leveling tools to measure a surface topology of the substrate, for e.g., focus control and scatterometry based tools for inspecting/measuring the exposed and/or etched product in process control. In each case, a radiation source is required. For various reasons, including measurement robustness and accuracy, broadband or white light radiation sources are increasingly used for such metrology applications. It would be desirable to improve on present devices for better control (e.g., multiple wavelength or wavelength band selection, wavelength-based intensity control) of broadband radiation.

SUMMARY

According to a first aspect of the invention, there is provided an optical arrangement for aberration correction, comprising: a beam dispersing element for spatially dispersing a broadband radiation beam in a first transverse direction; a focusing lens for focusing the broadband radiation beam subsequently to said dispersing, wherein said focusing lens is arranged such that the dispersed broadband radiation beam passes through at least one off-center position of the focusing lens in at least one pass, wherein said off-center position is a position displaced from a center of the focusing lens in a second transverse direction, wherein the first transverse direction and the second transverse direction are mutually perpendicular and parallel to a focal plane of the focusing lens; and at least one aberration compensating lens displaced in the second transverse direction with respect to at least part of the broadband radiation beam so as to substantially compensate for lateral chromatic aberration imposed by the focusing lens on the at least part of the broadband radiation beam.

According to a second aspect of the invention, there is provided a method for optimizing an optical arrangement according to the first aspect, comprising: determining an amount of aberration imposed by the focusing lens on the broadband radiation beam; and displacing the at least one aberration compensating lens with respect to the broadband radiation beam to impose an amount of counter-aberration on the broadband radiation beam so as to substantially compensate the aberration imposed by the focusing lens.

Other aspects of the invention comprise metrology device comprising an optical arrangement according the first aspect.

BRIEF DESCRIPTION OF THE DRAWINGS

Embodiments of the invention will now be described, by way of example only, with reference to the accompanying schematic drawings, in which:

- Figure 1 depicts a schematic overview of a lithographic apparatus;
- Figure 2 depicts a schematic overview of a lithographic cell;
- Figure 3 depicts a schematic representation of holistic lithography, representing a cooperation between three key technologies to optimize semiconductor manufacturing;
- Figure 4 depicts a schematic overview of a scatterometry apparatus used as a metrology device, which may comprise a radiation source according to embodiments of the invention;
- Figure 5 depicts a schematic overview of a level sensor apparatus which may comprise a radiation source according to embodiments of the invention;
- Figure 6 depicts a schematic overview of an alignment sensor apparatus which may comprise a radiation source according to embodiments of the invention;
- Figure 7A depicts schematically transmission of a broadband optical beam through a singlet lens resulting in a large amount of lateral chromatic aberration;
- Figure 7B depicts schematically transmission of a broadband optical beam through a singlet lens resulting in a large amount of axial chromatic aberration;
- Figure 7C depicts schematically transmission of a broadband optical beam through an achromatic lens resulting in a significantly lower amount of chromatic aberration;
- Figure 8A shows a top view of a broadband optical arrangement comprising a beam dispersing element for spatially dispersing a broadband optical beam and an optical lens for focusing the dispersed broadband optical beam into a plurality focus spots;
- Figure 8B shows a side view of the broadband optical arrangement of Figure 8A wherein the dispersed broadband optical beam travels through the center of the optical lens in the Y direction;
- Figure 8C shows a side view of the broadband optical arrangement of Figure 8A wherein the dispersed broadband optical beam travels through an off-center position of the optical lens in the Y direction;
- Figure 9A shows different focus spots of different wavelengths in the focal plane of the optical lens when arranged for on-axis focusing in the Y direction (e.g., as shown in Figure 8B);
- Figure 9B shows different focus spots of different wavelengths $\lambda_1, \lambda_1, \lambda_3, \lambda_4, \lambda_5$ in the focal plane of the optical lens when arranged for off-axis focusing in the Y direction (e.g., as shown in Figure 8C);
- Figure 10A shows a top view of a grating light valves (GLV) based wavelength selector wherein a broadband optical beam passes through an achromatic lens two times both at an off-center position in the Y direction;
- Figure 10B shows a side view of the GLV based wavelength selector (e.g., as shown in Figure 10A) and a spot diagram showing simulated focus spots of the output beam;
- Figures 11(a), 11(b) and 11(c) depict schematically a grating light valve, illustrating its basic operation in (a) a top view, (b) an end-on view in a first configuration and (c) an end-on view in a second configuration;
- Figure 12 shows a side view of a GLV based wavelength selector in accordance with an embodiment and a spot diagram showing simulated focus spots of the output beam, wherein a broadband optical beam passes through an achromatic lens two times both at an off-center position in the Y direction and an output lens is displaced in the Y direction to optimize the overlapping of focus spots of output beam;
- Figure 13 shows a side view of another GLV based wavelength selector in accordance with an embodiment and a spot diagram showing simulated focus spots of the output beam, wherein a broadband optical beam passes through an achromatic lens two times with only the second pass being at an off-center position in the Y direction and an output lens is displaced in the Y direction to optimize the overlapping of focus spots of output beam;
- Figure 14(a) depicts schematically one example of diffraction-based overlay metrology devices; Figure 14(b) is a representation of an illumination pupil; Figure 14(c) is a representation of a detection pupil and Figure 14(d) shows the arrangement of the imaging lens with respect to the four quarters of the detection pupil; and Figure 14(e) shows an example image of the overlay target;
- Figure 15(a) depicts schematically one example of diffraction-based overlay metrology devices equipped with four aberration compensating lenses; Figure 15(b) is a representation of an illumination pupil; Figure 15(c) is a representation of a detection pupil and Figure 15(d) shows the arrangement of the four aberration compensating lenses with respect to the four quarters of the detection pupil; and Figure 15(e) shows an example image of the overlay target; and

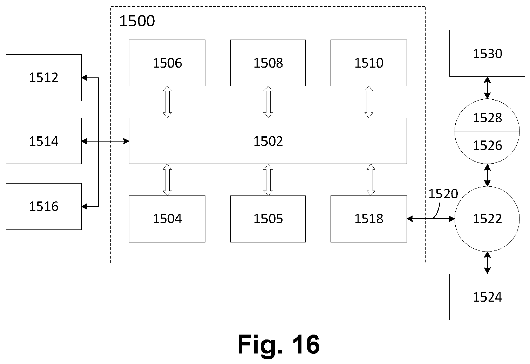

- Figure 16 depicts a block diagram of a computer system for controlling a broadband radiation source.

DETAILED DESCRIPTION

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

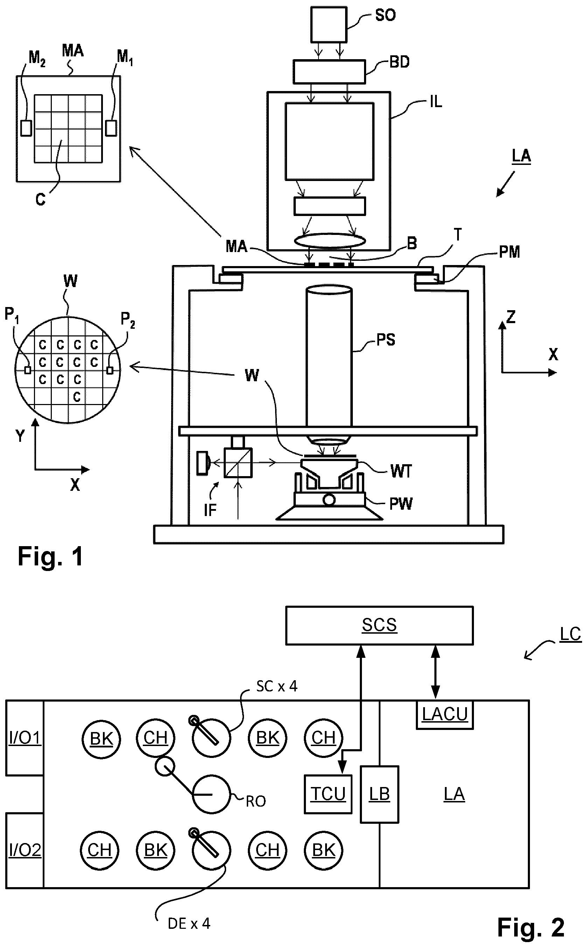

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks PI, P2. Although the substrate alignment marks PI, P2 as illustrated occupy dedicated target portions, they may be located in spaces between target portions. Substrate alignment marks PI, P2 are known as scribe-lane alignment marks when these are located between the target portions C.

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

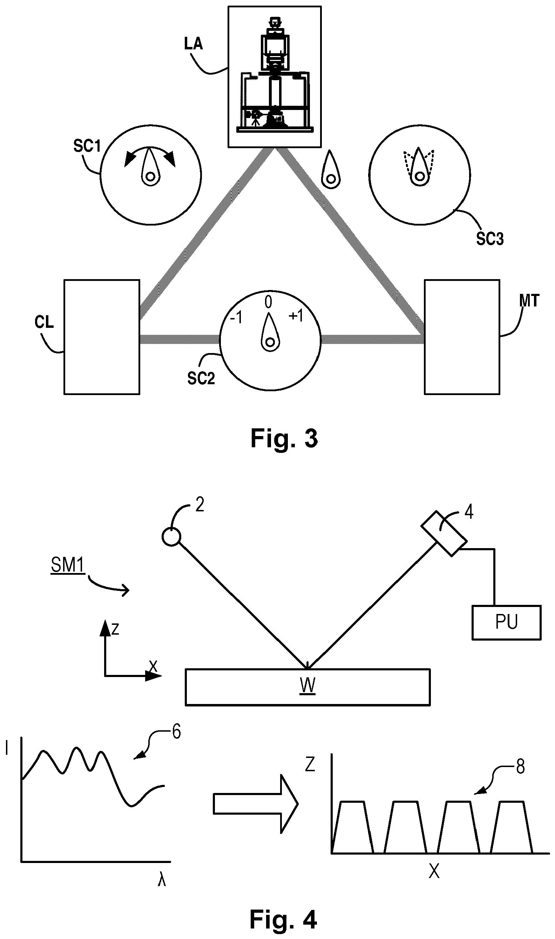

Typically the patterning process in a lithographic apparatus LA is one of the most critical steps in the processing which requires high accuracy of dimensioning and placement of structures on the substrate W. To ensure this high accuracy, three systems may be combined in a so called "holistic" control environment as schematically depicted in Fig. 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - typically within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Fig. 3 by the double arrow in the first scale SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MT) to predict whether defects may be present due to e.g. sub-optimal processing (depicted in Fig. 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Fig. 3 by the multiple arrows in the third scale SC3).

In lithographic processes, it is desirable to make frequently measurements of the structures created, e.g., for process control and verification. Tools to make such measurement are typically called metrology tools MT. Different types of metrology tools MT for making such measurements are known, including scanning electron microscopes or various forms of scatterometer metrology tools MT. Scatterometers are versatile instruments which allow measurements of the parameters of a lithographic process by having a sensor in the pupil or a conjugate plane with the pupil of the objective of the scatterometer, measurements usually referred as pupil based measurements, or by having the sensor in the image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers may measure gratings using light from soft x-ray and visible to near-IR wavelength range.

In a first embodiment, the scatterometer MT is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In a second embodiment, the scatterometer MT is a spectroscopic scatterometer MT. In such spectroscopic scatterometer MT, the radiation emitted by a radiation source is directed onto the target and the reflected or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer MT is an ellipsometric scatterometer. The ellipsometric scatterometer allows for determining parameters of a lithographic process by measuring scattered radiation for each polarization states. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

In one embodiment of the scatterometer MT, the scatterometer MT is adapted to measure the overlay of two misaligned gratings or periodic structures by measuring asymmetry in the reflected spectrum and/or the detection configuration, the asymmetry being related to the extent of the overlay. The two (typically overlapping) grating structures may be applied in two different layers (not necessarily consecutive layers), and may be formed substantially at the same position on the wafer. The scatterometer may have a symmetrical detection configuration as described e.g. in co-owned patent application EP1,628,164A, such that any asymmetry is clearly distinguishable. This provides a straightforward way to measure misalignment in gratings. Further examples for measuring overlay error between the two layers containing periodic structures as target is measured through asymmetry of the periodic structures may be found in PCT patent application publication no. WO 2011/012624 or US patent application US 20160161863, incorporated herein by reference in its entirety.

Other parameters of interest may be focus and dose. Focus and dose may be determined simultaneously by scatterometry (or alternatively by scanning electron microscopy) as described in US patent application US2011-0249244, incorporated herein by reference in its entirety. A single structure may be used which has a unique combination of critical dimension and sidewall angle measurements for each point in a focus energy matrix (FEM - also referred to as Focus Exposure Matrix). If these unique combinations of critical dimension and sidewall angle are available, the focus and dose values may be uniquely determined from these measurements.

A metrology target may be an ensemble of composite gratings, formed by a lithographic process, mostly in resist, but also after etch process for example. Typically the pitch and line-width of the structures in the gratings strongly depend on the measurement optics (in particular the NA of the optics) to be able to capture diffraction orders coming from the metrology targets. As indicated earlier, the diffracted signal may be used to determine shifts between two layers (also referred to 'overlay') or may be used to reconstruct at least part of the original grating as produced by the lithographic process. This reconstruction may be used to provide guidance of the quality of the lithographic process and may be used to control at least part of the lithographic process. Targets may have smaller sub-segmentation which are configured to mimic dimensions of the functional part of the design layout in a target. Due to this sub-segmentation, the targets will behave more similar to the functional part of the design layout such that the overall process parameter measurements resembles the functional part of the design layout better. The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled mode, it may also be possible to measure different targets simultaneously, thus determining different processing parameters at the same time.

Overall measurement quality of a lithographic parameter using a specific target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717A1incorporated herein by reference in its entirety.

A metrology apparatus, such as a scatterometer, is depicted in Figure 4. It comprises a broadband (white light) radiation projector 2 which projects radiation onto a substrate 6. The reflected or scattered radiation is passed to a spectrometer detector 4, which measures a spectrum 10 (i.e. a measurement of intensity as a function of wavelength) of the specular reflected radiation. From this data, the structure or profile giving rise to the detected spectrum may be reconstructed by processing unit PU, e.g. by Rigorous Coupled Wave Analysis and non-linear regression or by comparison with a library of simulated spectra as shown at the bottom of Figure 3. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

Overall measurement quality of a lithographic parameter via measurement of a metrology target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016/0161863 and published US patent application US 2016/0370717A1incorporated herein by reference in its entirety.

Another type of metrology tool used in IC manufacture is a topography measurement system, level sensor or height sensor. Such a tool may be integrated in the lithographic apparatus, for measuring a topography of a top surface of a substrate (or wafer). A map of the topography of the substrate, also referred to as height map, may be generated from these measurements indicating a height of the substrate as a function of the position on the substrate. This height map may subsequently be used to correct the position of the substrate during transfer of the pattern on the substrate, in order to provide an aerial image of the patterning device in a properly focus position on the substrate. It will be understood that "height" in this context refers to a dimension broadly out of the plane to the substrate (also referred to as Z-axis). Typically, the level or height sensor performs measurements at a fixed location (relative to its own optical system) and a relative movement between the substrate and the optical system of the level or height sensor results in height measurements at locations across the substrate.

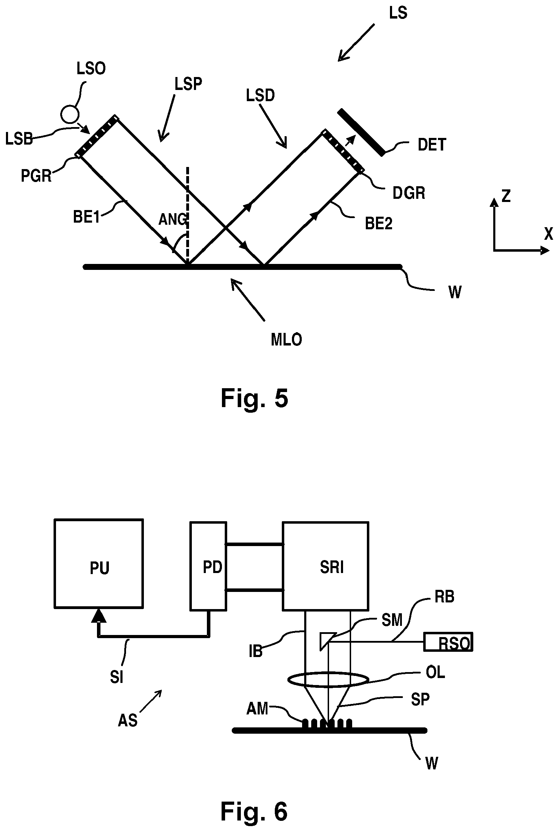

An example of a level or height sensor LS as known in the art is schematically shown in Figure 5, which illustrates only the principles of operation. In this example, the level sensor comprises an optical system, which includes a projection unit LSP and a detection unit LSD. The projection unit LSP comprises a radiation source LSO providing a beam of radiation LSB which is imparted by a projection grating PGR of the projection unit LSP. The radiation source LSO may be, for example, a narrowband or broadband light source, such as a supercontinuum light source, polarized or non-polarized, pulsed or continuous, such as a polarized or non-polarized laser beam. The radiation source LSO may include a plurality of radiation sources having different colors, or wavelength ranges, such as a plurality of LEDs. The radiation source LSO of the level sensor LS is not restricted to visible radiation, but may additionally or alternatively encompass UV and/or IR radiation and any range of wavelengths suitable to reflect from a surface of a substrate.

The projection grating PGR is a periodic grating comprising a periodic structure resulting in a beam of radiation BE1 having a periodically varying intensity. The beam of radiation BE1 with the periodically varying intensity is directed towards a measurement location MLO on a substrate W having an angle of incidence ANG with respect to an axis perpendicular (Z-axis) to the incident substrate surface between 0 degrees and 90 degrees, typically between 70 degrees and 80 degrees. At the measurement location MLO, the patterned beam of radiation BE1 is reflected by the substrate W (indicated by arrows BE2) and directed towards the detection unit LSD.

In order to determine the height level at the measurement location MLO, the level sensor further comprises a detection system comprising a detection grating DGR, a detector DET and a processing unit (not shown) for processing an output signal of the detector DET. The detection grating DGR may be identical to the projection grating PGR. The detector DET produces a detector output signal indicative of the light received, for example indicative of the intensity of the light received, such as a photodetector, or representative of a spatial distribution of the intensity received, such as a camera. The detector DET may comprise any combination of one or more detector types.

By means of triangulation techniques, the height level at the measurement location MLO can be determined. The detected height level is typically related to the signal strength as measured by the detector DET, the signal strength having a periodicity that depends, amongst others, on the design of the projection grating PGR and the (oblique) angle of incidence ANG.

The projection unit LSP and/or the detection unit LSD may include further optical elements, such as lenses and/or mirrors, along the path of the patterned beam of radiation between the projection grating PGR and the detection grating DGR (not shown).

In an embodiment, the detection grating DGR may be omitted, and the detector DET may be placed at the position where the detection grating DGR is located. Such a configuration provides a more direct detection of the image of the projection grating PGR.

In order to cover the surface of the substrate W effectively, a level sensor LS may be configured to project an array of measurement beams BE1 onto the surface of the substrate W, thereby generating an array of measurement areas MLO or spots covering a larger measurement range.

Various height sensors of a general type are disclosed for example in US7265364 and US7646471, both incorporated by reference. A height sensor using UV radiation instead of visible or infrared radiation is disclosed in US2010233600A1, incorporated by reference. In WO2016102127A1, incorporated by reference, a compact height sensor is described which uses a multi-element detector to detect and recognize the position of a grating image, without needing a detection grating.

Another type of metrology tool used in IC manufacture is an alignment sensor. A critical aspect of performance of the lithographic apparatus is therefore the ability to place the applied pattern correctly and accurately in relation to features laid down in previous layers (by the same apparatus or a different lithographic apparatus). For this purpose, the substrate is provided with one or more sets of marks or targets. Each mark is a structure whose position can be measured at a later time using a position sensor, typically an optical position sensor. The position sensor may be referred to as "alignment sensor" and marks may be referred to as "alignment marks".

A lithographic apparatus may include one or more (e.g. a plurality of) alignment sensors by which positions of alignment marks provided on a substrate can be measured accurately. Alignment (or position) sensors may use optical phenomena such as diffraction and interference to obtain position information from alignment marks formed on the substrate. An example of an alignment sensor used in current lithographic apparatus is based on a self-referencing interferometer as described in US6961116. Various enhancements and modifications of the position sensor have been developed, for example as disclosed in US2015261097A1. The contents of all of these publications are incorporated herein by reference.

Figure 6 is a schematic block diagram of an embodiment of a known alignment sensor AS, such as is described, for example, in US6961116, and which is incorporated by reference. Radiation source RSO provides a beam RB of radiation of one or more wavelengths, which is diverted by diverting optics onto a mark, such as mark AM located on substrate W, as an illumination spot SP. In this example the diverting optics comprises a spot mirror SM and an objective lens OL. The illumination spot SP, by which the mark AM is illuminated, may be slightly smaller in diameter than the width of the mark itself.

Radiation diffracted by the alignment mark AM is collimated (in this example via the objective lens OL) into an information-carrying beam IB. The term "diffracted" is intended to include zero-order diffraction from the mark (which may be referred to as reflection). A self-referencing interferometer SRI, e.g. of the type disclosed in US6961116 mentioned above, interferes the beam IB with itself after which the beam is received by a photodetector PD. Additional optics (not shown) may be included to provide separate beams in case more than one wavelength is created by the radiation source RSO. The photodetector may be a single element, or it may comprise a number of pixels, if desired. The photodetector may comprise a sensor array.

The diverting optics, which in this example comprises the spot mirror SM, may also serve to block zero order radiation reflected from the mark, so that the information-carrying beam IB comprises only higher order diffracted radiation from the mark AM (this is not essential to the measurement, but improves signal to noise ratios).

Intensity signals SI are supplied to a processing unit PU. By a combination of optical processing in the block SRI and computational processing in the unit PU, values for X- and Y-position on the substrate relative to a reference frame are output.

A single measurement of the type illustrated only fixes the position of the mark within a certain range corresponding to one pitch of the mark. Coarser measurement techniques are used in conjunction with this to identify which period of a sine wave is the one containing the marked position. The same process at coarser and/or finer levels may be repeated at different wavelengths for increased accuracy and/or for robust detection of the mark irrespective of the materials from which the mark is made, and materials on and/or below which the mark is provided. The wavelengths may be multiplexed and demultiplexed optically so as to be processed simultaneously, and/or they may be multiplexed by time division or frequency division.

In this example, the alignment sensor and spot SP remain stationary, while it is the substrate W that moves. The alignment sensor can thus be mounted rigidly and accurately to a reference frame, while effectively scanning the mark AM in a direction opposite to the direction of movement of substrate W. The substrate W is controlled in this movement by its mounting on a substrate support and a substrate positioning system controlling the movement of the substrate support. A substrate support position sensor (e.g. an interferometer) measures the position of the substrate support (not shown). In an embodiment, one or more (alignment) marks are provided on the substrate support. A measurement of the position of the marks provided on the substrate support allows the position of the substrate support as determined by the position sensor to be calibrated (e.g. relative to a frame to which the alignment system is connected). A measurement of the position of the alignment marks provided on the substrate allows the position of the substrate relative to the substrate support to be determined.

Metrology tools MT, such as a scatterometer, topography measurement system, or position measurement system mentioned above may use radiation originating from a radiation source to perform a measurement. The properties of the radiation used by a metrology tool may affect the type and quality of measurements that may be performed. For some applications, it may be advantageous to use multiple radiation frequencies to measure a substrate, for example broadband radiation may be used. Multiple different frequencies may be able to propagate, irradiate, and scatter off a metrology target with no or minimal interference with other frequencies. Therefore different frequencies may for example be used to obtain more metrology data simultaneously. Different radiation frequencies may also be able to interrogate and discover different properties of a metrology target. Broadband radiation may be useful in metrology systems MT such as for example level sensors, alignment mark measurement systems, scatterometry tools, or inspection tools. A broadband radiation source may be a supercontinuum source.

In many applications such as the aforementioned metrology applications, a broadband optical system is often used to transfer a broadband output radiation from a broadband radiation source to an application plane (e.g., a wafer plane). In addition to enabling an efficient (or a low loss) transfer of a broadband radiation, such an optical system may be further configured to control or adjust one or more characteristics of the broadband output radiation so as to obtain, for example, a desired transverse beam profile, a desired temporal profile, and/or a desired spectral profile.

The broadband optical system may comprise various different reflective (e.g., optical mirrors) and/or transmissive (e.g., optical lenses) optical elements which are typically optimized for reflecting or transmitting the broadband output radiation. For example, each optical element may comprise one or more optical coatings that are either highly transmissive (in the case of a transmissive optical element) or highly reflective (in the case of a reflective optical element) at least in the wavelength range of the broadband output radiation. However, due to the impact of material absorption and/or dispersion, optical elements, in particular transmissive optical elements may become incapable of maintaining their designed performance when the spectral coverage of the broadband output radiation becomes sufficiently wide. Consequently, such performance degradation of optical elements may cause optical loss and/or distortion and thus result in changes in the characteristics of broadband output radiation that are undesirable by the downstream application. Here, material dispersion means the refractive index of the transmissive optical element varies with the wavelength of light.

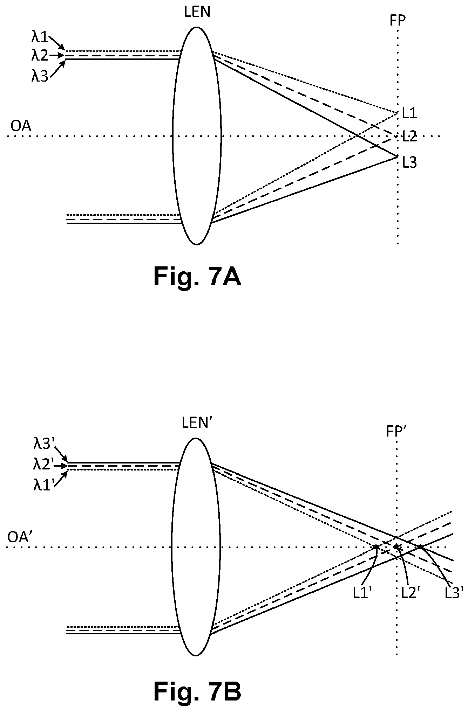

One example type of optical distortion to is chromatic aberration which occurs when an optical lens is used to focus a broadband optical beam. There are two types of chromatic aberration: lateral (or transverse) chromatic aberration and axial chromatic aberration, which are respectively illustrated in Figures 7A and 7B. As shown in Figure 7A, lateral aberration occurs when different wavelengths $\lambda_1$, $\lambda_1$, $\lambda_3$ (e.g., blue, green, and red wavelengths) are focused at different transverse positions in the focal plane FP of an optical lens LEN. Wavelength $\lambda_2$ may correspond to the designed (or nominal) wavelength at which the lens LEN is designed and manufactured. Thus, wavelength $\lambda_2$ is focused at an on-axis (i.e. on optical axis OA) position L2 in the focal plane FP, whereas other wavelengths $\lambda_1$ and $\lambda_3$ are focused at different positions L1, L3 in the focal plane FP due to the impact of material dispersion of the lens LEN. As shown in Figure 7B, axial aberration occurs when different wavelengths $\lambda_1'$, $\lambda_2'$, $\lambda_3'$ are focused at different axial positions L1', L2', L3' along the optical axis OA' of an optical lens LEN'. Thus, different wavelengths $\lambda_1'$, $\lambda_2'$, $\lambda_3'$ correspond to different focal lengths. Here, a focal length is defined as the distance between the lens and the focus position. In this example, wavelength $\lambda_2'$ may correspond to the designed (or nominal) wavelength at which the lens LEN' is designed and manufactured. Thus, the focus position L2' of wavelength $\lambda_2'$ is sufficiently close the designed focus position, whereas the focus positions of other wavelengths $\lambda_1'$, $\lambda_3'$ are more deviated from the designed focus position due to the impact of material dispersion of the lens LEN'.

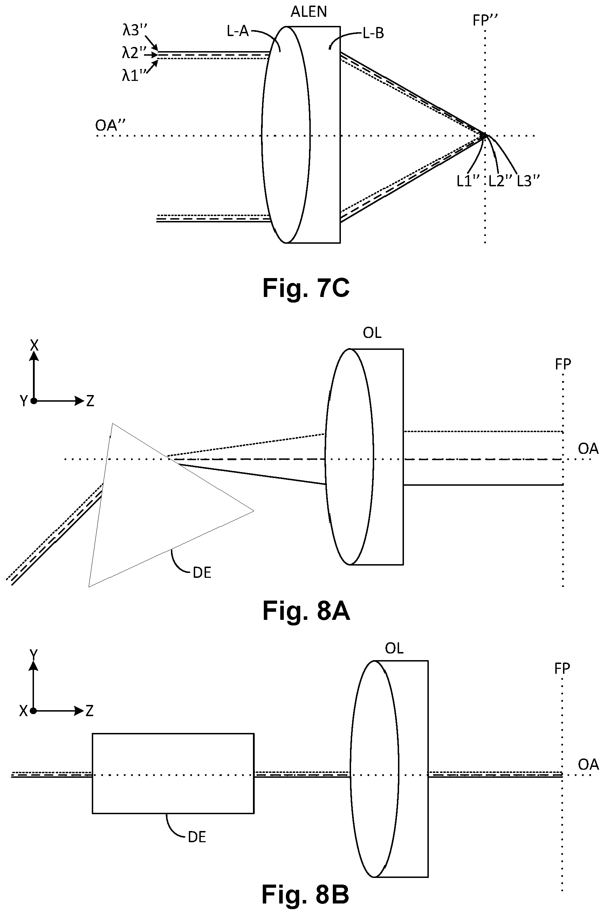

Although both types of chromatic aberration can occur together, lateral chromatic aberration is typically observed at short focal lengths while axial chromatic aberration is typically observed at long focal lengths. It is noted that the optical lenses LEN, LEN' shown in Figures 7A and 7B are both singlet lenses made of one type of optical glass. To minimize or correct for chromatic aberration as well as other aberrations (e.g., spherical aberration), achromatic lenses (or achromats) have been developed and are now widely used in optical systems. An achromatic lens is a compound lens in which two or more materials with different refractive indices and different dispersions are assembled together. Figure 7C schematically illustrates focusing of a broadband optical beam by an example achromatic lens ALEN. The example achromatic lens ALEN is formed by assembling (e.g., optical bonding) two lens elements L-A, L-B together. Such a two-element achromatic lens ALEN is also known as achromatic doublet. The two lens elements L-A, L-B may be made of for example crown glass and flint glass, respectively. As shown in Figure 7C and in contrast to singlet lenses (e.g., as shown in Figures 7A and 7B), the combination of two lens elements L-A, L-B is capable of reducing or minimizing both lateral and axial chromatic aberration and consequently the focus positions L1", L2", L3" of the respective wavelengths $\lambda_1"$, $\lambda_2"$, $\lambda_3"$ are much closer to each other as well as to the designed (or nominal) position. Although chromatic aberration is effectively reduced in the case of on-axis focusing (e.g., as shown in Figure 7C), the off-axis performance of an achromatic lens is significantly worse than the on-axis performance. More details are described below with reference to Figures 8A-8C.

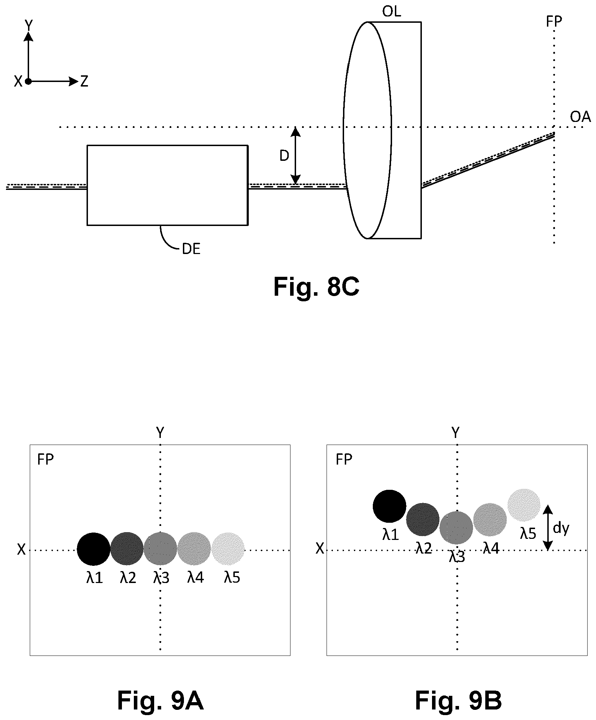

Figures 8A and 8B show respectively a top view and a side view of a broadband optical arrangement comprising a beam dispersing element DE (e.g., a prism) configured to spatially disperse a broadband optical beam and an optical lens OL (e.g., an achromatic doublet as shown in Figure 7C) configured to focus the dispersed broadband optical beam into a plurality of focus spots. The broadband optical arrangement is configured such that the broadband optical beam is spatially dispersed in the X direction and all the wavelengths of the optical beam travel through the center position of the optical lens OL in the Y direction (or the on-axis position in the Y-direction). Figure 9A shows different focus spots

of different wavelengths $\lambda_1$, $\lambda_1$, $\lambda_3$, $\lambda_4$, $\lambda_5$ in the focal plane FP of the optical lens OL when arranged for on-axis focusing in the Y direction. Since the performance (e.g., chromatic aberration) of the optical lens OL is optimized (e.g., minimized) for on-axis focusing, the position differences in the Y direction between different focus spots of different wavelengths $\lambda_1$, $\lambda_1$, $\lambda_3$, $\lambda_4$, $\lambda_5$ are therefore minimized or negligible. As such, the plurality of focus spots of different wavelengths $\lambda_1$, $\lambda_1$, $\lambda_3$, $\lambda_4$, $\lambda_5$ form a straight focus line substantially in the X direction. However, as a result of being spatially dispersed in the X direction, some wavelengths (e.g., at the periphery of the dispersed optical beam) of the broadband optical beam travel through an off-center position of the optical lens OL in the X direction and thus experience a greater amount of chromatic aberration than those travel through the center position of optical lens OL in the X direction (or the path along the optical axis OA of the optical lens OL). As such, the position differences in the X direction between different focus spots of different wavelengths $\lambda_1$, $\lambda_2$, $\lambda_3$, $\lambda_4$, $\lambda_5$ are sub-optimal (or not minimized).

Figure 8C shows a side view of the broadband optical arrangement (e.g., as shown in Figure 8A or 8B) wherein the dispersed broadband optical beam travels through an off-center position of the optical lens OL which is offset by a distance D in the Y-direction with respect to the optical axis OA of the optical lens OL. This means the dispersed broadband optical beam travels through an off-center position of the optical lens OL in the Y direction and consequently experiences a higher amount of chromatic aberration than the on-axis focusing scenario illustrated in Figure 8B. Figure 9B shows different focus spots of different wavelengths $\lambda_1$, $\lambda_2$, $\lambda_3$, $\lambda_4$, $\lambda_5$ in the focal plane FP of the optical lens OL when arranged for off-axis focusing in the Y direction. For off-axis focusing as shown in Figure 8C, the larger the offset distance D is (or the closer the optical beam is to the periphery of the optical lens OL), the stronger aberration the optical beam will experience. As a consequence, the wavelengths (e.g., $\lambda_1$ and $\lambda_5$) that are located further away from the optical axis OA of the optical lens are more displaced or shifted in the Y direction than the ones located closer to (e.g., $\lambda_2$ and $\lambda_4$) or on (e.g., $\lambda_3$) the optical axis OA. As such, the plurality of focus spots of different wavelengths $\lambda_1$, $\lambda_2$, $\lambda_3$, $\lambda_4$, $\lambda_5$ form a curved focus line in the X-Y plane. The position differences in the X direction between different focus spots of different wavelengths $\lambda_1$, $\lambda_2$, $\lambda_3$, $\lambda_4$, $\lambda_5$ are similar to those of the on-axis focusing scenario (e.g., as shown in Figure 9A). Note that depending on the aberration imposed by the lens OL, the plurality of focus spots of different wavelengths $\lambda_1$, $\lambda_2$, $\lambda_3$, $\lambda_4$, $\lambda_5$ can be shifted to the opposite side of the X axis (or shifted downwardly instead of upwardly as shown in Figure 9B and they may not be symmetric about the Y-axis.

In many applications, it may be desirable to deliberately pass a broadband optical beam through an off-center position of an optical lens OL, like the off-axis focusing scenario illustrated in Figure 8C, such that the broadband optical beam passes through the optical lens OL two or more times. Such a multipass arrangement obviates the need of any additional lenses (e.g., an additional collimating lens for collimating the focused broadband optical beam) and thus reduces the total number of optical elements in an optical system, thereby allowing for a lower cost and more compact system design. However, to do this the off-axis chromatic aberration should be better managed or compensated.

Assuming the optical lens is an achromatic doublet consisting of two lens elements L-A and L-B (e.g., as shown in Figure 7C), the Y-axis displacement $dy_{dC}$ of the focus spots is given by [J.M.Geary, "Introduction to Lens Design with Practical ZEMAX® Examples", published by Willmann-Bell Inc., 2002, incorporated herein by reference]:

$$dy_{dC} = y\left(\left(\frac{P_{dc}}{V_d}\right)_A \varnothing_A + \left(\frac{P_{dc}}{V_d}\right)_B \varnothing_B\right), \qquad [1]$$

where y denotes the Y-axis offset of the entrance position of an optical beam with respect to the optical axis of the lens (e.g., the offset D shown in Figure 8C), $V_d$ denotes the Abbe number with respect to the Fraunhofer d-line; $\varnothing_A$ and $\varnothing_B$ denote the refractive powers of lens element L-A and lens element L-B, respectively; $P_{dC}$ denotes the partial dispersion ratio of the lens element. To reduce or minimize the off-axis aberration, apochromat may be used. The part between the brackets of equation [1] is recognized as the condition for apochromatism which generally requires one additional lens element, i.e. at least three lens elements as opposed to a two-element achromatic lens (e.g., as shown in Figure 7C).

Due to the aging issue of conventional cemented optical lenses, wherein two or more lens elements are cemented together, it is preferable and advantageous to design and manufacture a multi-element lens in such a way that any two neighboring lens elements are interfaced with an air spacing. Transmission efficiency is one of the important parameters for a multi-element optical lens, and therefore it is desirable to use the fewest lens elements possible. This is because a higher number of lens elements means a higher number of air-glass interfaces and thus a higher transmission loss through lens elements. Designing and manufacturing an apochromatic lens that will work over a desired broadband wavelength (e.g., from 400 nm to 1600 nm) is also found to be very difficult. For example, many special glasses that are required for making an apochromatic lens are often soft and thus difficult to manufacture. Moreover, it is very challenging and sometimes impossible to fully compensate the dispersions of multiple lens elements of different glasses when the target wavelength range is too broad (e.g., from 400 nm to 1600 nm). Note that for the sake of simplicity, in the following paragraphs, the term "achromatic lens" refers specifically to achromatic lens having two lens elements or an achromatic doublet.

It is the object of the present disclosure to provide an effective and more practical approach to address the aforementioned issues. According to a first aspect of the present disclosure, there is provided an optical arrangement for aberration correction, comprising: a beam dispersing element for spatially dispersing a broadband radiation beam in a first transverse direction; a focusing lens for focusing the broadband radiation beam subsequently to said dispersing, wherein said focusing lens is arranged such that the dispersed broadband radiation beam passes through at least one off-center position of the focusing lens in at least one pass, wherein said off-center position is a position displaced from a center of the focusing lens in a second transverse direction, wherein the first transverse direction and the second transverse direction are mutually perpendicular and parallel to a focal plane of the focusing lens; and at least one aberration compensating lens displaced in the second transverse direction with respect to at least part of the broadband radiation beam so as to substantially compensate for lateral chromatic aberration imposed by the focusing lens on the at least part of the broadband radiation beam.

In an embodiment, the optical arrangement may comprise a spectral configuration element configured to selectively transmit, diffract, or reflect the at least part of the broadband radiation beam, the at least part of the broadband radiation beam comprising one or more wavelengths of the broadband radiation beam. In an embodiment, the spectral configuration element may comprise a grating light valve (GLV) comprising configurable diffractive structures for selectively reflecting or diffracting the broadband radiation beam incident thereon into the at least part of the broadband radiation beam. Accordingly, the at least part of the broadband radiation beam may be e.g., a spectrally shaped beam having been modulated by the GLV.

The embodiments below are described in relation to a wavelength selecting apparatus based on the GLV technology. However, it will be appreciated that the fundamental concept on which all the embodiments are based can be used for many other different applications.

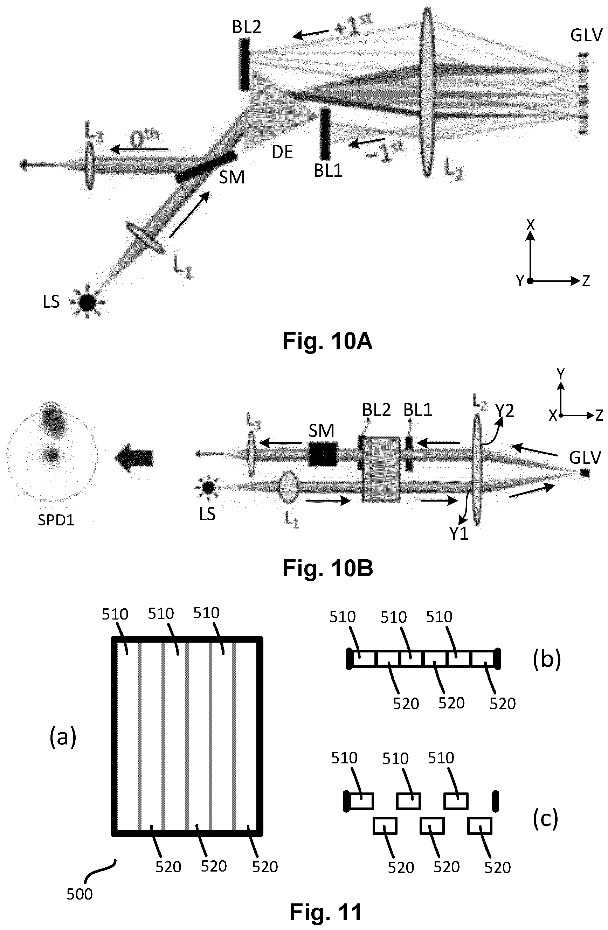

By way of example and with reference to Figures 10A and 10B, the example wavelength selector is configured such that a broadband optical beam is off-axis focused and subsequently captured by a single achromatic lens L2. The example wavelength selector uses the GLV technology such as marketed by Silicon Light Machines (SLM), and described in US6947613B, which is incorporated herein by reference. A GLV is an electrically-programmable diffraction grating based on Micro-ElectroMechanical Systems (MEMS) technology.

Figures 11(a)-11(c) illustrate the working principal. Figures 11(a)-11(c) are schematic illustrations of a GLV pixel or component 500 from above and end-on, respectively. Please note that the GLV component shown in Figures 11(a)-11(c) is only an example design, other different GLV designs (e.g., the "true-GLV" design used in the G1088 and G8192 modules marketed by SLM) can also be used in the wavelength selector of Figures 10A and 10B. The GLV component comprises alternating GLV reflective ribbons of two types: static or bias ribbons 510 which are typically grounded along with a common electrode and driven or active ribbons 520 which are driven by an electronic driver channel. A GLV module may comprise any number of these GLV components 500 arranged in an array (e.g., a 1D or 2D array). The active and bias ribbons may be essentially identical other than in how they are driven. When no voltage is applied to the active ribbons 520, they are co-planar with the bias ribbons, a configuration illustrated in Figure 11(b). In this configuration, the GLV acts essentially as a mirror, with incident light being specularly reflected (i.e., forming specularly reflected radiation or zeroth diffraction order radiation). When a voltage is applied to the active ribbons 520, as illustrated in Figure 1 1(c), they deflect relative to the bias ribbons 510, establishing a square-well diffraction grating. In this state, incident light is diffracted into fixed diffraction angles. The ratio of light reflected with respect to light diffracted can be continuously varied by controlling the voltage on the active ribbons 520, which controls the magnitude of their deflection. As such, the amount of light diffracted by the GLV can be controlled in an analog fashion from zero (full specular reflection) to all incident light (zero specular reflection). This control of the amount of reflected radiation with respect to the amount of radiation diffracted into nonzero diffraction orders may be referred to as modulating the illumination within the context of this disclosure.

The GLV module may be used in a zeroth order mode such that the diffracted radiation is blocked/dumped and the specularly reflected (zeroth diffraction order) radiation is used. This has the advantage of preserving etendue. As such, an aperture stop may be provided in a pupil plane which with the aim of maximizing transmission of the zeroth order, and maximizing blocking (minimizing transmission) of the first orders (and other diffraction orders).

Referring back to Figures 10A and 10B, in the example wavelength selector, a broadband optical beam emitted from a broadband light source LS is dispersed in the X direction by a beam dispersing element DE, which may be for example a prism or a grating. The dispersing of the broadband optical beam is achieved based on the principle that the direction of the light emerging from the beam dispersing element DE is wavelength dependent. The broadband optical beam may be collimated by a first optical lens $L_1$ before being dispersed by the beam dispersing element DE. The dispersed broadband optical beam is then focused by a second optical lens $L_2$ onto the ribbons of the GLV which is placed substantially at the focal plane of the second lens $L_2$. The beam dispersing element DE and the second optical lens $L_2$ are arranged in much the same way as the optical arrangement shown in Figure 8C. That is to say, the dispersed broadband optical beam travels through at a first off-center position Y1 in the Y direction (with reference to the coordinate system in Figure 10B).

Affected by the off-axis chromatic aberration, the focus spots of different wavelengths of the broadband optical beam may form a curved focus line on the GLV (e.g., as shown in Figure 9B) where each focus position (or focus spot) corresponds to a certain wavelength. The GLV may be configured in a zeroth order mode and is operable to apply a certain spatial modulation to the focused broadband optical beam so as to selectively reflect desired wavelengths and diffract away undesired wavelengths. In some embodiments, the GLV may be operated in a wavelength selection mode to select only one or more chosen wavelengths. That is to say, the ribbons of the GLV that correspond to the selected wavelengths may be set to equal heights such that they act like a standard mirror for the selected wavelengths. The other ribbons are actuated in such a way that they form a grating, such that undesired wavelengths incident on these ribbons are diffracted into higher diffraction orders, e.g., -1$^{st}$ and +1$^{st}$ diffraction orders. These higher diffraction orders are then blocked or dumped by the beam blocks BL1, BL2, respectively. The GLV may be operated also in intermediate modes, to form a grating which partially reflects and partially diffracts the incident radiation so as to attenuate but not completely block a certain wavelength. The degree of attenuation may be controlled via the ribbon configuration. In this way, the spectral constitution of the output radiation can be controlled.

The spatially modulated reflected (zeroth order) radiation from the GLV is captured by the second optical lens $L_2$ wherein the spatially modulated optical beam passes through the lens $L_2$ at a second off-center position Y2 in the Y direction. The spatially modulated optical beam is recombined on a return path using the same dispersing element DE as was used to disperse the beam on the outward path. The return path within the dispersing element DE may be substantially parallel with and displaced in the Y direction with respect to the outward path. The recombined optical beam is directed by a steering mirror SM towards a third optical lens $L_3$ which acts as an output lens and focuses the optical beam into a metrology device MET; e.g., via a suitable optical fiber such as a single mode photonic crystal fiber.

With reference to Figure 10B, the spot diagram SPD1 shows a plurality of simulated focus spots of the output beam, each focus spot corresponding to a different wavelength of the output beam. The positions of the plurality of focus spots may be predominantly determined by the lateral chromatic aberration imposed by the second optical lens $L_2$. In an ideal case where the optical beam is free of aberrations (e.g., lateral chromatic aberration) and passes through the center of the third optical lens $L_3$ (i.e. on-axis focusing), the focus spots should substantially overlap with each other. However, as a result of passing through the second optical lens $L_2$ twice both at off-center positions, the output beam is not free of aberrations and thus the focus spots are spatially displaced with respect to each other. When such spatial displacements are on the same order as or greater than the core diameter of the transport fiber, some wavelengths may not be coupled into the fiber, thereby resulting in a significant in-coupling loss and a distortion in the spectrum of the output beam.

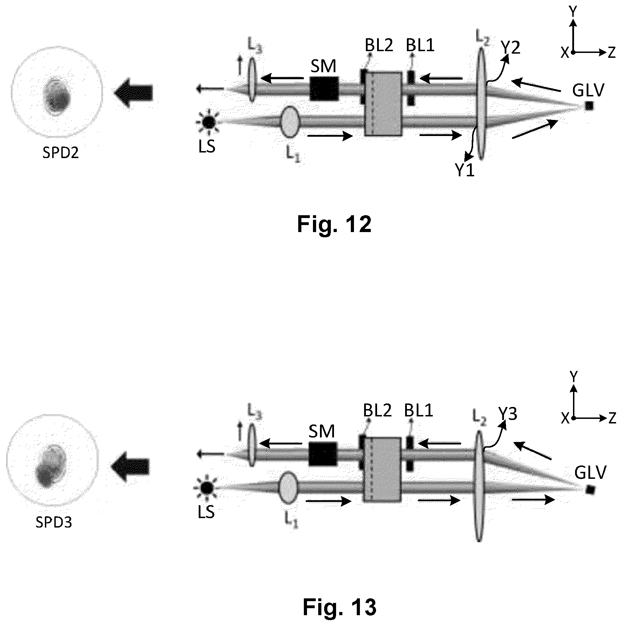

With reference to Figure 12, an embodiment of a wavelength selector may comprise the same optical components as that shown in Figures 10A and 10B. The second optical lens $L_2$ may also be arranged in such a way that the broadband optical beam passes through the lens twice at respective different off-center positions in the Y direction (e.g., Y1 and Y2 positions). To compensate the aberrations, in particular the lateral chromatic aberration, imposed by the second optical lens $L_2$, the third optical lens $L_3$ may be displaced in the Y direction with respect to the output beam to impose a suitable amount of counter-aberration (e.g., lateral chromatic aberration) to the output beam. Note that the third optical lens $L_3$ can be displaced in other directions in the transverse plane (e.g., the X-Y plane defined by the coordinate system in Figure 12) that is perpendicular to the path of the output beam. Consequently, differences in the positions of the plurality of focus spots of the output beam are minimized, as shown in the spot diagram SPD2 in Figure 12. In other words, the focus spots of the output beam are substantially overlaid on top of each other. Note that the focus spots of the dispersed broadband optical beam may form a curved line on the GLV as a result of off-axis focusing (e.g., as shown in Figure 8C and Figure 9B). In some extreme cases, the focus line is may be too curved to be properly spatially modulated by the GLV.

With reference to Figure 13, another embodiment of the wavelength selector may be arranged such that the broadband optical beam passes through the lens twice with only the second pass (or the return pass) being at an off-center position in the Y direction (e.g., Y3 position). In this embodiment, the GLV may be rotated with respect to the incident optical beam allow the reflected spatially modulated radiation to pass through the second lens $L_2$ at the off-center position Y3. Benefitting from on-axis focusing (on the first or outward pass), the focus spots of the dispersed broadband optical beam may form a straight line on the GLV. This may help to maintain the effectiveness of the GLV and may also relax the tolerances on the optical alignment for the GLV. Similar to the embodiment shown in Figure 12, the third optical lens $L_3$ may be displaced in the Y direction with respect to the output beam to impose a suitable amount of counter-aberration (e.g., lateral chromatic aberration) to the output beam. Consequently, differences in the positions of the plurality of focus spots of the output beam are minimized, as shown in the spot diagram SPD3 in Figure 13.

For both embodiments shown in Figures 12 and 13, alternatively or in addition to imposing counter-aberration via lens $L_3$, the first optical lens $L_1$ may be displaceable in the Y direction with respect to the broadband optical beam so as to introduce a suitable amount of aberration (e.g., lateral chromatic aberration) to fully or partially pre-compensate the lateral chromatic aberration imposed by the second optical lens $L_2$. In the case of the third optical lens $L_3$ being arranged for on-axis focusing, the magnitude of the lateral chromatic aberration imposed by the first optical lens $L_1$ may

be substantially equal to the lateral chromatic aberration imposed by the second optical lens $L_2$. In the case of the third optical lens being configured for off-axis focusing (e.g., displaced in the Y direction with respect to the output beam), the combined magnitude of lateral chromatic aberration imposed by the first optical lens $L_1$ and the third optical lens $L_3$ may be substantially equal to the lateral chromatic aberration imposed by the second optical lens $L_2$. The target of the aberration compensation may be to minimize position differences between the focus spots of the output beam such that the focus spots of the optical beam after the third optical lens $L_3$ are substantially overlaid on top of each other. In an embodiment, the first optical lens $L_1$ and/or the third optical lens $L_3$ may be displaced in an opposite manner (e.g., displaced in an opposite direction) as compared to the displacement of the second optical lens $L_2$. Referring back to Figure 12, the first optical lens $L_1$ may be displaced to substantially minimize the curvature of the focus line on the GLV and the third optical lens $L_3$ may be displaced to minimize the position differences of the plurality of focus spots of the output beam. This example implementation may have an advantage of allowing for a smaller (and thus less expensive) achromatic lens L2 than the one employed in the embodiment of Figure 13. However, the limitation of this implementation may be that this embodiment can only reduce or minimize the curvature of the focus line on the GLV, which means the focus line on the GLV may still be slightly curved (or have residual non-straightness). By comparison, allowing the dispersed broadband radiation to pass through the center of the second optical lens $L_2$ (on its first pass) can eliminate the curvature and thus produce a straight focus line on the GLV.

The broadband radiation beam may comprise a spectrum partially overlapping with the range of 200 nm to 2000 nm, or the range of 400 nm to 1600 nm. In an embodiment, the broadband radiation beam may comprise a spectrum spanning from 200 nm to 2000 nm. In an embodiment, the broadband radiation beam may comprise a spectrum spanning from 500 nm to 900 nm. The broadband radiation beam may comprise a spectrum having a full width half maximum (FWHM) width of at least 500 nm, at least 300 nm, at least 200 nm.

According to a second aspect of the present disclosure, there is provided a method for optimizing an output beam of the optical arrangement of the first aspect. The method comprising determining an amount of aberration imposed by the focusing lens on the broadband radiation beam; and displacing the at least one aberration compensating lens with respect to the broadband radiation beam to impose an amount of counter-aberration on the broadband radiation beam so as to substantially compensate the aberration imposed by the focusing lens.

In an embodiment, the at least one aberration compensating lens may be an output lens located downstream of the focusing lens, the step of determining an amount of aberration may comprise: simulating or measuring one or more positions of the output radiation at a focal plane of the output lens; and determining a wavelength dependent variation in the one or more positions of the output radiation; and calculating the amount of aberration based on the determined wavelength dependent variation in the one or more positions of the output radiation.

In an embodiment, the at least one aberration compensating lens may comprise one or both of: an output lens located downstream of the focusing lens and an input lens located upstream of the beam dispersing element, the method comprising: displacing one or both of the input lens and output lens to said amount of counter-aberration the output lens located downstream of the focusing lens and the input lens located upstream of the beam dispersing element, the method comprising: displacing the input lens to impose a second amount of counter-aberration that in combination with the counter-aberration imposed by the output lens is substantially equal to the amount of aberration imposed by the focusing lens.

It will be appreciated that the above embodiments are provided for the purpose of describing the proposed concept and are not intended to limit the scope of the present disclosure. Of course, other embodiments can be envisaged.

For example, the concept of displacing one optical lens with respect to an optical beam to compensate aberration imposed by another optical lens may be applied to diffraction-based metrology devices. Diffraction-based overlay metrology using dark field imaging of the diffraction orders enables overlay measurements on smaller targets. Examples of dark field imaging metrology can be found in international patent applications WO 2009/078708 and WO 2009/106279 which are hereby incorporated by reference in their entirety.

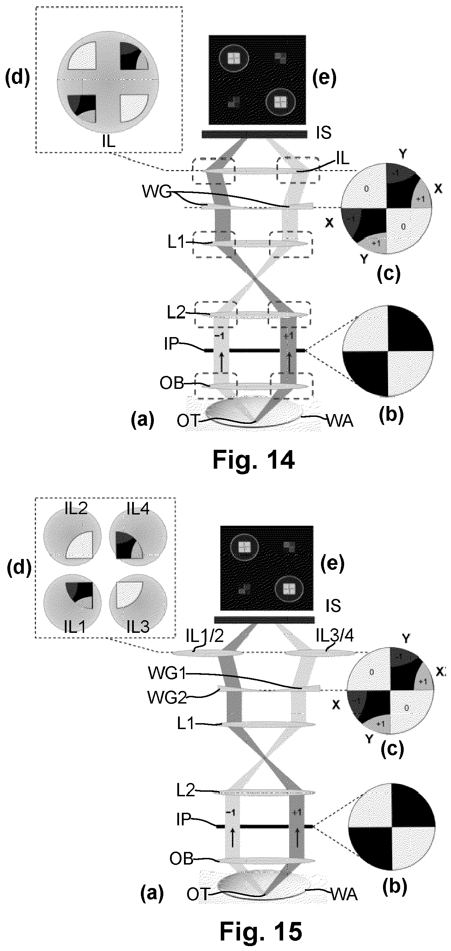

Figure 14(a) schematically illustrates one example of a diffraction-based overlay metrology device. As shown in the figure, an overlay target OT (e.g., a micro-diffraction based overlay μOPB target) on a wafer WA is illuminated using a quartered illumination mask defining an illumination NA comprising two diagonally opposed quarters (e.g., the upper left and lower right quarters). The other two diagonally opposed quarters (e.g., the upper right and lower left quarters) are used for detection and define the detection NA. Figure 14(b) is a representation of the illumination pupil IP of the device wherein gray quarters are used for illumination while black quarters are used for detection. In this example device, the radiation scattered from the overlay target OT comprising +1st, -1st and (optionally) zeroth diffraction orders are collected by the objective lens OB and then transferred through an intermediate lens assembly comprising a first lens L1 and a second lens L2. A 4-part wedge assembly WG is placed at the detection pupil plane of the device and arranged to redirect each of the diffraction orders (including the zeroth order if captured) to respective different beam paths and therefore to respective different detector plane locations. Figure 14(c) is an exemplary representation of the detection pupil of the device wherein the upper left and lower right quarters of the detection pupil only contain the zeroth diffraction orders and the upper right and lower left quarters only contain the -1st and +1st diffractions orders. Where the overlay target OT comprises an X-pad (having a grating aligned in the X direction) and a Y-pad (having a grating aligned in the Y direction), each pad may result in a -1$^{st}$ diffraction order and a +1$^{st}$ diffraction order, as shown in Figure 14(c). All the diffraction orders are then focused by an imaging lens IL onto an image sensor IS. Such an arrangement enables simultaneous imaging of the +1, -1 and zeroth orders.

Figure 14(d) shows the corresponding areas of the imaging lens IL used for imaging the four quarters of the detection pupil to the image sensor IS. Figure 14(e) shows an example image of the overlay target OT captured by the image sensor IS. In the detected image, the X- and Y-pads lie adjacent to each other. If aberrations are present, there will be XY crosstalk between these pads, which will negatively affect the overlay retrieval result. One group of the aberration contributors is due to the fact that the -1$^{st}$ and +1$^{st}$ diffraction orders go through high NA (edge) areas of a lens, where the lens quality or performance is expected to be poorer than the lower NA part (off-axis aberration described above in relation to Figure 8C). The dashed boxes in Figure 14 mark where the diffraction orders go through the high NA (edge) areas of the lens.

To compensate the off-axis aberration, it is proposed to replace the imaging lens IL before the image sensor IS by four separate imaging lenses IL1-IL4 (acting as aberration compensating lenses), each of which is arranged to focus one quarter of the detection pupil. Figure 15(a) schematically illustrates one example implementation of the proposed method. Compared to the example shown in Figure 14(a), the only change is the replacement of the single imaging lens with the four separate imaging lenses IL1-IL4. Thus, Figures 15(b), 15(c) and 15(e) are similar to Figures 14(b), 14(c) and 14(e), respectively. As shown in Figure 15(a) and Figure 15(d), the four imaging lenses IL1-IL4 may be individually laterally displaced with respect to their corresponding quarters such that respective radiation in each quarter of the detection pupil passes through an edge area of a respective lens IL1, IL2, IL3, IL4 in an opposite manner to that of the other lenses of the device. Here, lateral displacement refers to displacement in a transverse plane that is perpendicular to the optical axis of the device. By way of example, the lens IL1 may be laterally displaced with respect to the lower left quarter of the detection pupil in such a way that radiation within that quarter passes through the upper right area of the lens IL1. The direction of the lateral displacement of the lens IL1 may be determined based on the fact that the same radiation passes through a lower left area of each of the other lenses (e.g., the lenses OB, L2, L1) in the device. The amount of the lateral displacement and the optical properties (e.g. focal length) of the four lenses may be chosen in such a way that they compensate the aberrations induced by having the diffraction orders going through the high NA areas of the other lenses (e.g., the lenses OB, L2, L1).

Figure 15 is a block diagram that illustrates a computer system 1500 that may assist in implementing the methods and flows disclosed herein. Computer system 1500 includes a bus 1502 or other communication mechanism for communicating information, and a processor 1504 (or multiple processors 1504 and 1505) coupled with bus 1502 for processing information. Computer system 1500 also includes a main memory 1506, such as a random access memory (RAM) or other dynamic storage device, coupled to bus 1502 for storing information and instructions to be executed by processor 1504. Main memory 1506 also may be used for storing temporary variables or other intermediate information during execution of instructions to be executed by processor 1504. Computer system 1500 further includes a read only memory (ROM) 1508 or other static storage device coupled to bus 1502 for storing static information and instructions for processor 1504. A storage device 1510, such as a magnetic disk or optical disk, is provided and coupled to bus 1502 for storing information and instructions.

Computer system 1500 may be coupled via bus 1502 to a display 1512, such as a cathode ray tube (CRT) or flat panel or touch panel display for displaying information to a computer user. An input device 1514, including alphanumeric and other keys, is coupled to bus 1502 for communicating information and command selections to processor 1504. Another type of user input device is cursor control 1516, such as a mouse, a trackball, or cursor direction keys for communicating direction information and command selections to processor 1504 and for controlling cursor movement on display 1512. This input device typically has two degrees of freedom in two axes, a first axis (e.g., x) and a second axis (e.g., y), that allows the device to specify positions in a plane. A touch panel (screen) display may also be used as an input device.

One or more of the methods as described herein may be performed by computer system 1500 in response to processor 1504 executing one or more sequences of one or more instructions contained in main memory 1506. Such instructions may be read into main memory 1506 from another computer-readable medium, such as storage device 1510. Execution of the sequences of instructions contained in main memory 1506 causes processor 1504 to perform the process steps described herein. One or more processors in a multi-processing arrangement may also be employed to execute the sequences of instructions contained in main memory 1506. In an alternative embodiment, hard-wired circuitry may be used in place of or in combination with software instructions. Thus, the description herein is not limited to any specific combination of hardware circuitry and software.

The term "computer-readable medium" as used herein refers to any medium that participates in providing instructions to processor 1504 for execution. Such a medium may take many forms, including but not limited to, non-volatile media, volatile media, and transmission media. Non-volatile media include, for example, optical or magnetic disks, such as storage device 1510. Volatile media include dynamic memory, such as main memory 1506. Transmission media include coaxial cables, copper wire and fiber optics, including the wires that comprise bus 1502. Transmission media can also take the form of acoustic or light waves, such as those generated during radio frequency (RF) and infrared (IR) data communications. Common forms of computer-readable media include, for example, a floppy disk, a flexible disk, hard disk, magnetic tape, any other magnetic medium, a CD-ROM, DVD, any other optical medium, punch cards, paper tape, any other physical medium with patterns of holes, a RAM, a PROM, and EPROM, a FLASH-EPROM, any other memory chip or cartridge, a carrier wave as described hereinafter, or any other medium from which a computer can read.

Various forms of computer readable media may be involved in carrying one or more sequences of one or more instructions to processor 1504 for execution. For example, the instructions may initially be borne on a magnetic disk of a remote computer. The remote computer can load the instructions into its dynamic memory and send the instructions over a telephone line using a modem. A modem local to computer system 1500 can receive the data on the telephone line and use an infrared transmitter to convert the data to an infrared signal. An infrared detector coupled to bus 1502 can receive the data carried in the infrared signal and place the data on bus 1502. Bus 1502 carries the data to main memory 1506, from which processor 1504 retrieves and executes the instructions. The instructions received by main memory 1506 may optionally be stored on storage device 1510 either before or after execution by processor 1504.

Computer system 1500 also preferably includes a communication interface 1518 coupled to bus 1502. Communication interface 1518 provides a two-way data communication coupling to a network link 1520 that is connected to a local network 1522. For example, communication interface 1518 may be an integrated services digital network (ISDN) card or a modem to provide a data communication connection to a corresponding type of telephone line. As another example, communication interface 1518 may be a local area network (LAN) card to provide a data communication connection to a compatible LAN. Wireless links may also be implemented. In any such implementation, communication interface 1518 sends and receives electrical, electromagnetic or optical signals that carry digital data streams representing various types of information.

Network link 1520 typically provides data communication through one or more networks to other data devices. For example, network link 1520 may provide a connection through local network 1522 to a host computer 1524 or to data equipment operated by an Internet Service Provider (ISP) 1526. ISP 1526 in turn provides data communication services through the worldwide packet data communication network, now commonly referred to as the "Internet" 1528. Local network 1522 and Internet 1528 both use electrical, electromagnetic or optical signals that carry digital data streams. The signals through the various networks and the signals on network link 1520 and through communication interface 1518, which carry the digital data to and from computer system 1500, are exemplary forms of carrier waves transporting the information.

Computer system 1500 may send messages and receive data, including program code, through the network(s), network link 1520, and communication interface 1518. In the Internet example, a server 1530 might transmit a requested code for an application program through Internet 1528, ISP 1526, local network 1522 and communication interface 1518. One such downloaded application may provide for one or more of the techniques described herein, for example. The received code may be executed by processor 1504 as it is received, and/or stored in storage device 1510, or other non-volatile storage for later execution. In this manner, computer system 1500 may obtain application code in the form of a carrier wave.

Further embodiments have been disclosed in the following list of numbered clauses:

1. An optical arrangement for aberration correction, comprising:

a beam dispersing element for spatially dispersing a broadband radiation beam in a first transverse direction;
a focusing lens for focusing the broadband radiation beam subsequently to said dispersing,

wherein said focusing lens is arranged such that the dispersed broadband radiation beam passes through at least one off-center position of the focusing lens in at least one pass, wherein said off-center position is a position displaced from a center of the focusing lens in a second transverse direction, wherein the first transverse direction and the second transverse direction are mutually perpendicular and parallel to a focal plane of the focusing lens; and
at least one aberration compensating lens displaced in the second transverse direction with respect to at least part of the broadband radiation beam so as to substantially compensate for lateral chromatic aberration imposed by the focusing lens on the at least part of the broadband radiation beam.

2. An optical arrangement as defined in clause 1, being arranged such that said broadband radiation beam passes through an off-center position of said at least one aberration compensating lens.

3. An optical arrangement as defined in clause 2, being arranged such that said off-center position of said at least one aberration compensating lens is compensatory in terms of lateral chromatic aberration to said at least one off-center position of the focusing lens.

4. An optical arrangement as defined in any preceding clause, further comprising a spectral configuration element configured to selectively transmit, diffract, or reflect the at least part of the broadband radiation beam, the at least part of the broadband radiation beam comprising one or more wavelengths of the broadband radiation beam.

5. An optical arrangement as defined in clause 4, wherein the spectral configuration element is located substantially at said focal plane of the focusing lens.

6. An optical arrangement as defined in clause 5, wherein the spectral configuration element comprises a grating light valve comprising configurable diffractive structures for selectively reflecting or diffracting the broadband radiation beam incident thereon into the at least part of the broadband radiation beam.

7. An optical arrangement as defined in clause 6, wherein said beam dispersing element is further arranged to recombine the at least part of the broadband radiation beam into an output beam.

8. An optical arrangement as defined in clause 7, being arranged such that said broadband radiation beam passes through said center of the focusing lens to the spectral configuration element and the at least part of the broadband radiation beam passes through said at least one off-center position of the focusing lens from the spectral configuration element.

9. An optical arrangement as defined in clause 8, wherein the aberration compensating lens is displaced, with respect to said broadband radiation beam, in a direction opposite to a direction in which the focusing lens is displaced.

10. An optical arrangement as defined in clause 7, being arranged such that said broadband radiation beam passes through a first off-center position of the focusing lens to the spectral configuration element and the at least part of the broadband radiation beam passes through a second off-center position of the focusing lens from the spectral configuration element.

11. An optical arrangement as defined in clause 10, wherein the first and second off-center positions are symmetrical about the optical axis.

12. An optical arrangement as defined in any of clauses 7-11, further comprising an output lens arranged to focus the output beam; and wherein the at least one aberration compensating lens is arranged to compensate the lateral chromatic aberration imposed by the focusing lens such that wavelength dependent variation in a position of the output beam at a focal plane of the output lens is minimized.

13. An optical arrangement as defined in clause 12, wherein the at least one aberration compensating lens comprises one or both of:

said output lens, located downstream of the focusing lens; and/or
an input lens located upstream of the beam dispersing element.

14. An optical arrangement as defined in any preceding clause, wherein one or more of the focusing lens and each at least one aberration compensating lens comprise an achromatic lens.

15. An optical arrangement as defined in clause 14, wherein the achromatic lens is an achromatic doublet.

16. An optical arrangement as defined in any preceding clause, wherein the beam dispersing element comprises a prism or a grating.

17. An optical arrangement as defined in any preceding clause, wherein the broadband radiation beam comprises a spectrum partially overlapping with the range of 200 nm to 2000 nm.

18. An optical arrangement as defined in any preceding clause, wherein the broadband radiation beam comprises a spectrum partially overlapping with the range of 400 nm to 1600 nm.

19. An optical arrangement as defined in any preceding clause, wherein the broadband radiation beam comprises a spectrum having a full width half maximum (FWHM) width of at least 500 nm.

20. An optical arrangement as defined in any preceding clause, wherein the broadband radiation beam comprises a spectrum having a FWHM width of at least 300 nm.

21. An optical arrangement as defined in any preceding clause, wherein the broadband radiation beam comprises a spectrum having a FWHM width of at least 200 nm.

22. An optical arrangement as defined in any preceding clause, wherein the broadband radiation beam comprises a spectrum spanning from 500 nm to 900 nm.

23. A metrology device comprising an optical arrangement as defined in any preceding clause.

24. A metrology device as defined in clause 23, comprising a scatterometer metrology apparatus, a level sensor or an alignment sensor.

25. A method for optimizing an optical arrangement as defined in any of clauses 1 to 22, comprising:

determining an amount of aberration imposed by the focusing lens on the broadband radiation beam; and
displacing the at least one aberration compensating lens with respect to the at least part of the broadband radiation beam to impose an amount of counter-aberration on the at least part of the broadband radiation beam so as to substantially compensate the aberration imposed by the focusing lens.

26. A method as defined in clause 25, wherein the step of determining an amount of aberration comprises:

simulating or measuring one or more positions of an output beam at a focal plane of the output lens, said output beam being formed from the at least part of the broadband radiation beam;
determining a wavelength dependent variation in the one or more positions of the output beam; and
calculating the amount of aberration based on the determined wavelength dependent variation in the one or more positions of the output radiation.

27. A method as defined in clause 25 or clause 26, wherein the at least one aberration compensating lens comprises one or both of:

an output lens located downstream of the focusing lens and
an input lens located upstream of the beam dispersing element, the method comprising:
displacing one or both of the input lens and output lens to said amount of counter-aberration.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1.  An optical arrangement for aberration correction, comprising:

a beam dispersing element for spatially dispersing a broadband radiation beam in a first transverse direction;
a focusing lens for focusing the broadband radiation beam subsequently to said dispersing,

wherein said focusing lens is arranged such that the dispersed broadband radiation beam passes through at least one off-center position of the focusing lens in at least one pass, wherein said off-center position is a position displaced from a center of the focusing lens in a second transverse direction, wherein the first transverse direction and the second transverse direction are mutually perpendicular and parallel to a focal plane of the focusing lens; and
at least one aberration compensating lens displaced in the second transverse direction with respect to at least part of the broadband radiation beam so as to substantially compensate for lateral chromatic aberration imposed by the focusing lens on the at least part of the broadband radiation beam.

2.  An optical arrangement as claimed in claim 1, being arranged such that said broadband radiation beam passes through an off-center position of said at least one aberration compensating lens.

3.  An optical arrangement as claimed in claim 2, being arranged such that said off-center position of said at least one aberration compensating lens is compensatory in terms of lateral chromatic aberration to said at least one off-center position of the focusing lens.

4.  An optical arrangement as claimed in any preceding claim, further comprising a spectral configuration element configured to selectively transmit, diffract, or reflect the at least part of the broadband radiation beam, the at least part of the broadband radiation beam comprising one or more wavelengths of the broadband radiation beam.

**5.** An optical arrangement as claimed in claim 4, wherein the spectral configuration element is located substantially at said focal plane of the focusing lens.

**6.** An optical arrangement as claimed in claim 5, wherein the spectral configuration element comprises a grating light valve comprising configurable diffractive structures for selectively reflecting or diffracting the broadband radiation beam incident thereon into the at least part of the broadband radiation beam.

**7.** An optical arrangement as claimed in claim 6, wherein said beam dispersing element is further arranged to recombine the at least part of the broadband radiation beam into an output beam.

**8.** An optical arrangement as claimed in claim 7, being arranged such that said broadband radiation beam passes through said center of the focusing lens to the spectral configuration element and the at least part of the broadband radiation beam passes through said at least one off-center position of the focusing lens from the spectral configuration element, and, optionally, the aberration compensating lens is displaced, with respect to said broadband radiation beam, in a direction opposite to a direction in which the focusing lens is displaced.

**9.** An optical arrangement as claimed in claim 7, being arranged such that said broadband radiation beam passes through a first off-center position of the focusing lens to the spectral configuration element and the at least part of the broadband radiation beam passes through a second off-center position of the focusing lens from the spectral configuration element, and, optionally, the first and second off-center positions are symmetrical about the optical axis.

**10.** An optical arrangement as claimed in any of claims 7-9, further comprising an output lens arranged to focus the output beam; and wherein the at least one aberration compensating lens is arranged to compensate the lateral chromatic aberration imposed by the focusing lens such that wavelength dependent variation in a position of the output beam at a focal plane of the output lens is minimized.

**11.** An optical arrangement as claimed in claim 12, wherein the at least one aberration compensating lens comprises one or both of:

said output lens, located downstream of the focusing lens; and/or
an input lens located upstream of the beam dispersing element.

**12.** An optical arrangement as claimed in any preceding claim, wherein the broadband radiation beam comprises a spectrum partially overlapping with the range of 200 nm to 2000 nm.

**13.** An optical arrangement as claimed in any preceding claim, wherein the broadband radiation beam comprises a spectrum having a FWHM width of at least 200 nm.

**14.** A metrology device comprising an optical arrangement as claimed in any preceding claim.

**15.** A method for optimizing an optical arrangement as claimed in any of claims 1 to 13, comprising:

determining an amount of aberration imposed by the focusing lens on the broadband radiation beam; and displacing the at least one aberration compensating lens with respect to the at least part of the broadband radiation beam to impose an amount of counter-aberration on the at least part of the broadband radiation beam so as to substantially compensate the aberration imposed by the focusing lens.

**Fig. 1**

**Fig. 2**

LA

SC1

SC3

CL

SC2

0

-1 +1

MT

**Fig. 3**

2

4

SM1

Z

X

PU

W

6

I

λ

Z

8

X

**Fig. 4**

LS

LSO

LSP

LSD

DET

LSB

PGR

DGR

BE1

ANG

BE2

Z

X

W

MLO

**Fig. 5**

PU

PD

SRI

RB

SM

IB

RSO

SI

OL

AS

AM

SP

W

**Fig. 6**

Fig. 7A

Fig. 7B

**Fig. 7C**

**Fig. 8A**

**Fig. 8B**

**Fig. 8C**

**Fig. 9A**

**Fig. 9B**

**Fig. 10A**

**Fig. 10B**

**Fig. 11**

**Fig. 12**

**Fig. 13**

Fig. 14

Fig. 15

Fig. 16

## EUROPEAN SEARCH REPORT

**Application Number**

EP 22 20 0778

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y<br><br>A | US 6 947 613 B1 (ROXLO CHARLES B [US]) 20 September 2005 (2005-09-20)<br>* figure 3 *<br>* column 7, line 7 – line 8 *<br>* column 4, line 28 – line 33 *<br>* column 4, line 43 – line 47 *<br>* column 5, line 25 – line 35 *<br>* column 6, line 10 – line 13 *<br>* column 6, line 35 – line 38 *<br>* column 1, line 6 – line 7 *<br>-----  | 1-7,9-15<br><br>8 | INV.<br>G02B27/00 |
| Y | US 4 927 250 A (SUDA SHIGEYUKI [JP]) 22 May 1990 (1990-05-22)<br>* column 7, line 11 – line 17 *<br>* figures 4A,4B,5A,5C *<br>----- | 1-7,9-15 | |

**TECHNICAL FIELDS SEARCHED (IPC)**

G02B

The present search report has been drawn up for all claims

| Place of search | Date of completion of the search | Examiner |
|---|---|---|
| Munich | 3 March 2023 | Navarro Fructuoso, H |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons
................................................................
& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 22 20 0778

This annex lists the patent family members relating to the patent documents cited in the above-mentioned European search report.
The members are as contained in the European Patent Office EDP file on
The European Patent Office is in no way liable for these particulars which are merely given for the purpose of information.

03-03-2023

| Patent document cited in search report | | Publication date | Patent family member(s) | | Publication date |
|---|---|---|---|---|---|
| US 6947613 | B1 | 20-09-2005 | NONE | | |
| US 4927250 | A | 22-05-1990 | JP | 2502282 B2 | 29-05-1996 |
| | | | JP | S61223819 A | 04-10-1986 |
| | | | US | 4927250 A | 22-05-1990 |

EPO FORM P0459

For more details about this annex : see Official Journal of the European Patent Office, No. 12/82

# EP 4 354 200 A1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 6952253 B
- US 20100328655 A
- US 2011102753 A1
- US 20120044470 A
- US 20110249244 A
- US 20110026032 A
- EP 1628164 A
- US 451599
- US 11708678 B
- US 12256780 B
- US 12486449 B
- US 12920968 B
- US 12922587 B
- US 13000229 B
- US 13033135 B
- US 13533110 B
- US 13891410 B
- WO 2011012624 A
- US 20160161863 A
- US 20160370717 A
- US 20160370717 A1
- US 7265364 B
- US 7646471 B
- US 2010233600 A1
- WO 2016102127 A1
- US 6961116 B
- US 2015261097 A1
- US 6947613 B
- WO 2009078708 A
- WO 2009106279 A